Europäisches Patentamt

(19) **European Patent Office**

**Office européen des brevets**

(11) Numéro de publication : **0 179 693**
**B1**

(12) **FASCICULE DE BREVET EUROPÉEN**

(45) Date de publication du fascicule du brevet :
**09.08.89**

(51) Int. Cl.⁴ : **H 01 L 27/08**, H 01 L 21/82,
**H 01 L 29/78**

(21) Numéro de dépôt : **85401860.3**

(22) Date de dépôt : **24.09.85**

(54) **Structure de circuit intégré comportant des transistors CMOS à tenue en tension élevée, et son procédé de fabrication.**

(30) Priorité : 28.09.84 FR 8414988

(43) Date de publication de la demande :
30.04.86 Bulletin 86/18

(45) Mention de la délivrance du brevet :
09.08.89 Bulletin 89/32

(84) Etats contractants désignés :
**AT DE FR GB IT NL**

(56) Documents cités :
**EP--A-- 0 020 164**
**EP--A-- 0 070 101**
**FR--A-- 2 449 334**
**FR--A-- 2 464 561**
**US--A-- 4 300 150**
**INTERNATIONAL ELECTRON DEVICES MEETING
1982, 13-15 décembre 1982, pages 77-80, San Francisco, US; V. RUMENNIK et al.: "Integrated high and
low voltage CMOS technology"**

(73) Titulaire : **THOMSON-CSF**
**51, Esplanade du Général de Gaulle**
**F-92800 Puteaux (FR)**

(72) Inventeur : **Thomas, Gilles**
**THOMSON-CSF SCPI 173, bld Haussmann**
**F-75379 Paris Cedex 08 (FR)**

(74) Mandataire : **Rinuy, Santarelli et al**
**14, avenue de la Grande Armée**
**F-75017 Paris (FR)**

## Description

La présente invention concerne les circuits intégrés et plus particulièrement les circuits réalisés selon une technologie CMOS, c'est-à-dire incorporant sur un même substrat semiconducteur à la fois des transistors MOS à canal N et des transistors MOS à canal P. Cette technologie est utilisée notamment pour la réalisation de fonctions logiques et elle permet en particulier d'obtenir des circuits à faible consommation et travaillant à très basse tension (quelques volts).

Cependant, on désire parfois obtenir une tenue en tension beaucoup plus élevée que celle que permet la technologie normale CMOS ; c'est le cas par exemple pour des étages de sortie commandant des dispositifs spéciaux tels que des dispositifs de visualisation alimentés sous une tension de l'ordre d'une centaine de volts.

On a déjà proposé des structures de transistors MOS ayant une tenue en tension améliorée permettant de répondre à cet impératif ; ces transistors possèdent une région de drain qui n'est pas immédiatement adjacente à la région de canal (c'est-à-dire la région recouverte par la grille de commande), mais qui en est séparée par une région de même type de conductivité que la région de drain et de dopage beaucoup plus faible ; cette région est relativement large (plusieurs microns par exemple entre la région de drain fortement dopée et la région de canal) et elle sert à supporter une partie de la tension appliquée en permettant une extension vers le drain de la charge d'espace qui se développe lorsque le transistor est non conducteur.

Dans les quelques tentatives qui ont pu être jusqu'à maintenant pour réaliser sur un même substrat semiconducteur à la fois des transistors CMOS logiques et des transistors MOS haute tension, on a toujours proposé des structures qui ont l'inconvénient de nécessiter un nombre relativement élevé d'étapes de fabrication et un nombre élevé de masques différents.

Un but de l'invention est de proposer une structure et un procédé de réalisation de cette structure, qui permet une fabrication en un nombre d'étapes peu élevé et avec un nombre de masques également peu élevé, cette structure incorporant des transistors CMOS logiques (basse tension) et des transistors MOS haute tension à canal N et à canal P.

Un autre but de l'invention est de proposer une structure incorporant des transistors CMOS logiques et des transistors CMOS haute tension, cette structure étant telle qu'on puisse y incorporer aussi des transistors bipolaires sans modifier le procédé de fabrication. Il est en effet très souhaitable, dans un processus industriel de fabrication, que les étapes de procédé soient aussi universelles que possible pour qu'un grand nombre de produits très différents les uns des autres puissent suivre dans une large mesure une même chaine de fabrication. Ici, on veut que cela soit possible même si ces produits incorporent des éléments aussi différents que des transistors CMOS logiques (basse tension), des transistors CMOS haute tension et des transistors bipolaires.

FR-A-2 464 561 décrit des transistors CMOS à basse et à haute tension qui ne sont pas intégrés simultanément sur une pastille semiconductrice.

La structure de base que l'on propose ici pour la réalisation d'un circuit incorporant des transistors MOS logiques à canal N et à canal P et des transistors MOS haute tension à canal N et à canal P comprend :

— une pastille semi-conductrice constituée d'un substrat (10) recouvert d'une couche épitaxiale (16) peu dopée de type N ;

— des premières régions (20) de type P⁻ peu dopées, s'étendant à partir de la surface de la pastille semi-conductrice sur une partie substantielle de la profondeur de la couche épitaxiale (16), ces premières régions (20) constituant des caissons dans lesquels sont formés la source, le drain et le canal des transistors MOS basse tension à canal N ;

— des régions de type P⁺ fortement dopées (36, 38, 40, 44) moins profondes que les premières régions (20) de type P⁻, s'étendant à partir de la surface de la pastille semi-conductrice et constituant la source et le drain des transistors à canal P ;

— des régions de type N⁺ fortement dopées (48, 50, 52, 56) moins profondes que les premières régions (20) de type P⁻, s'étendant à partir de la surface de la pastille semi-conductrice et constituant la source et le drain des transistors à canal N ;

cette structure comprenant en outre :

— à chaque emplacement de transistor MOS haute tension à canal N, une seconde région (22) de type P⁻, de mêmes profil de concentration et profondeur que les premières régions (20) et constituant une région de canal (54) de ce transistor MOS haute tension à canal N, une région de source (56) de type N⁺ implantée dans ladite seconde région (22) de type P⁻, et une région de drain (52) de type N⁺, en dehors de la seconde région (22) de type P⁻ et séparée d'elle par une zone substantielle de la couche épitaxiale (16) de type N peu dopée, zone non directement contrôlée par la grille (33) du transistor et située entre ladite région de drain (52) et la seconde région (22) de type P⁻ ;

— à chaque emplacement de transistor MOS haute tension à canal P, une troisième région (24) de type P⁻, de mêmes profil de concentration et profondeur que lesdites premières (20) et secondes (22) régions de type P⁻, où est implantée une région de drain (40) de type P⁺, une région de canal (42) du transistor étant constituée par une portion de la couche épitaxiale (16) de type N peu dopée, adjacente à ladite troisième région (24) de type P⁻, la région de drain (40) implantée dans la troisième région (24), étant écartée de la région de canal (42) par une zone substantielle de la troisième région (24) de type P— non directement contrôlée par la grille (35) du transistor MOS haute tension à canal P, tandis que ce transistor présente une région de source (44) de type $P^+$ en dehors de ladite troisième région (24) de type P—.

Cette structure, dont la caractéristique la plus marquante est le fait que les transistors MOS haute tension, aussi bien à .canal N qu'à canal P, sont réalisés à partir de diffusions localisées dans une couche épitaxiée peu dopée et identiques à la diffusion des caissons d'isolement des MOS N basse tension, permet une réalisation qui est très simple et qui rend possible des extensions notamment à des structures où des transistors CMOS et des transistors bipolaires sont combinés sans qu'il soit nécessaire de changer le processus global de traitement des tranches de circuits intégrés.

Le procédé de fabrication selon l'invention se caractérise donc quant à lui par la formation (implantation/diffusion) de régions de type P— en une même étape, à partir de la surface de la couche épitaxiée de type N, non seulement aux endroits destinés à former des caissons englobant des transistors MOS à canal N, dans leur totalité (source + drain + canal) mais aussi dans des régions à l'intérieur desquelles on ne diffusera ultérieurement que la source (mais pas le drain) de transistors MOS à canal N ou que le drain (mais pas la source) de transistors à canal P.

D'autres caractéristiques et avantages de l'invention apparaîtront à la lecture de la description détaillée qûi suit et qui est faite en référence aux dessins annexés dans lesquels :

— les figures 1 à 7 représentent les étapes successives du procédé de fabrication selon l'invention ;

— la figure 8 représente en coupe transversale la structure d'un exemple de réalisation de circuit intégré selon l'invention, avant la mise en place d'interconnexions métalliques superficielles.

Sur ces figures, les échelles horizontales et verticales ne sont.pas respectées, pour faciliter la représentation.

Dans l'exemple de réalisation représenté, on part d'un substrat 10 de silicium de type P, étant entendu que dans certaines applications on pourrait partir de substrats différents ; par exemple un substrat $P/P^+$ c'est-à-dire un substrat de type P, fortement dopé sur sa face arrière seulement (notamment lorsqu'on veut réaliser dans le circuit un transistor de puissance bipolaire PNP vertical dont le collecteur est accessible par la face arrière) ; ou encore un substrat de type $N^+$, fortement dopé sur toute son épaisseur, par exemple si on veut réaliser dans le circuit un transistor bipolaire de puissance NPN vertical dont le collecteur est accessible par la face arrière du substrat.

Sur la face avant du substrat (face supérieure sur les figures), on effectue une première implantation localisée d'une impureté de type N (antimoine par exemple), avec une concentration élevée, pour former localement des régions 12 de type N— qui constitueront ultérieurement ce qu'on appelle des couches enterrées.

Cette implantation se fait à travers un masque de résine ouvert seulement aux endroits correspondant aux régions 12.

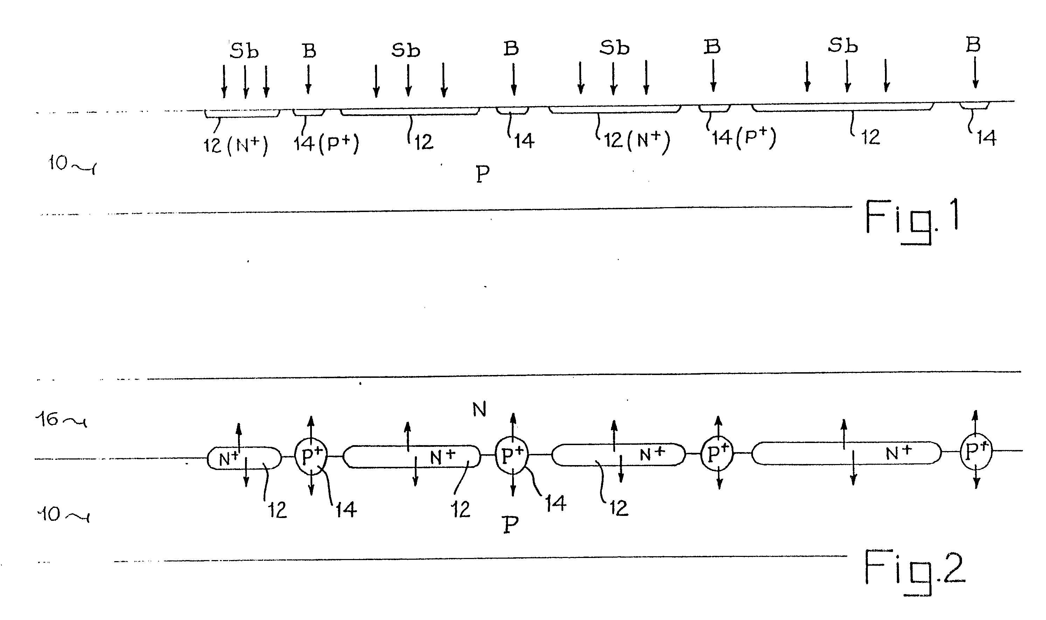

Cette implantation de type $N^+$ est suivie ultérieurement d'une croissance épitaxiale de silicium monocristallin sur toute la face supérieure du substrat 10. Toutefois, dans l'exemple de réalisation plus précisément décrit, on prévoit auparavant une étape supplémentaire due au fait que des zones d'isolement par jonction sont prévues entre les diverses zones actives de circuit, par exemple entre les différents transistors MOS qui n'ont pas leurs sources reliées au même potentiel ; plus précisément, l'isolement est fait par des murs d'isolement de type P traversant toute la couche épitaxiale depuis sa surface jusqu'au substrat de type P ; ces murs sont formés par une double diffusion d'impuretés de type P, à savoir une diffusion remontant par le bas depuis le substrat et un dopage par le haut depuis la surface de la couche épitaxiale. C'est pourquoi, avant l'étape de croissance épitaxiale, on procède à une deuxième implantation ionique sur la surface supérieure du substrat 10, avec une impureté de type P cette fois (par exemple du bore), cette implantation est localisée par un masque de résine ouvert aux endroits où un mur d'isolement est désiré et on obtient alors la structure de la figure 1 avec des régions 12 de type $N^+$ et des régions 14 de type $P^+$ affleurant à la surface du substrat.

On fait croître alors sur toute la surface supérieure du substrat une couche épitaxiale 16 de silicium monocristallin peu dopé, de type N ; pendant la croissance de cette couche, ainsi d'ailleurs que dans certaines étapes ultérieures de traitement thermique, les impuretés implantées précédemment diffusent à la fois vers le substrat 10 et vers la couche épitaxiale 16, comme cela est indiqué sur la figure 2.

Dans les figures suivantes, on a représenté les régions de couche enterrée 12 à cheval sur la frontière entre le substrat de départ de type P et la couche épitaxiale 16 qui le recouvre. Quant aux régions 14, elles diffusent d'une part vers le bas, réduisant l'influence du NPN latéral parasite formé par les couches enterrées, et d'autre part vers le haut où elles forment la partie inférieure des futurs murs d'isolement.

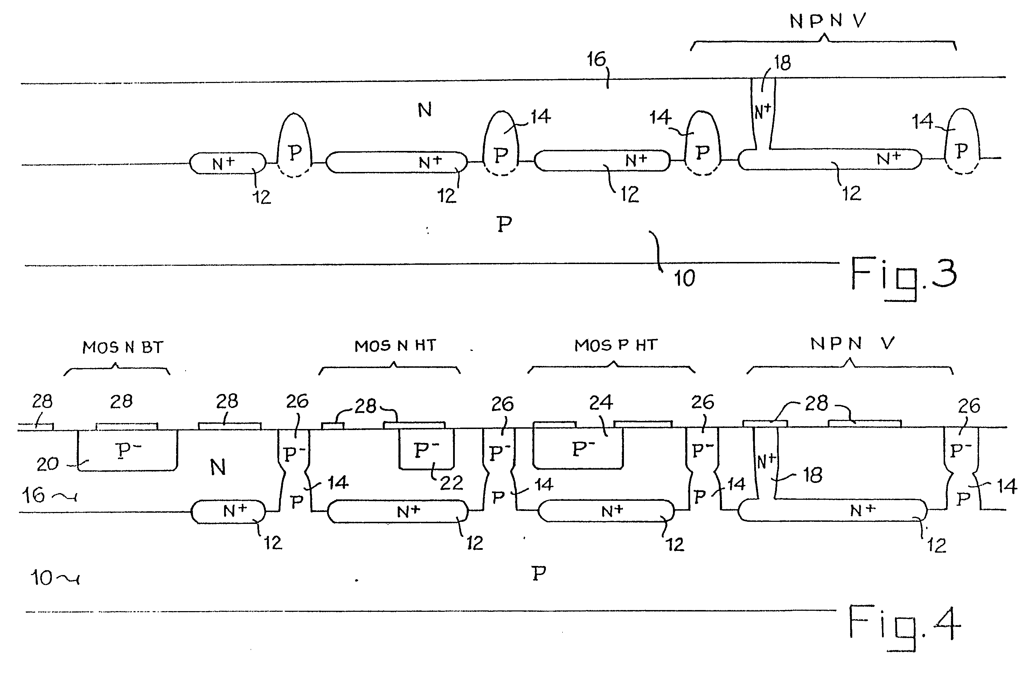

Dans l'exemple décrit, on a prévu que le circuit intégré comprend non seulement des transistors à effet de champ (MOS) mais aussi un transistor bipolaire NPN vertical dans lequel le courant de collecteur est recueilli par une portion de couche enterrée 12 située en-dessous de ce transistor. Dans ce cas, on crée un puits d'accès 18 à cette couche enterrée ; ce puits est une région de type $N^+$, fortement dopée, traversant la couche épitaxiale 16 depuis sa surface jusqu'à la couche enterrée. Le mieux est alors de réaliser ce puits d'accès par diffusion profonde de phosphore (prédépôt de $POCl_3$) immédiatement après la formation de la couche épitaxiale 16. La figure 3 représente la structure du circuit intégré à ce stade de la fabrication.

L'étape suivante est une étape fondamentale du procédé. Elle consiste à former localement des régions de type P peu dopées (qu'on désignera par régions P−), qui s'étendent à partir de la surface de la couche épitaxiale sur une partie de la profondeur de celle-ci (par exemple sur 7 à 8 microns de profondeur pour une couche épitaxiale de 15 microns).

La localisation de ces régions est la suivante :

1) Là où on désire réaliser des transistors MOS à canal N à faible tenue en tension (MOS N BT) notamment pour les fonctions logiques du circuit, on forme une région P− 20 qui constitue un caisson fermé dans lequel se situera la totalité d'un transistor MOS à canal N (ou même de plusieurs), c'est-à-dire à la fois la région de source, la région de drain et la région de canal, cette dernière étant constituée par la partie superficielle de la région 20 de type P−.

2) Là où on désire réaliser des transistors MOS à canal N à tenue en tension élevée (MOS N HT), par exemple pour des étages de sortie, on forme une région P− 22 à l'intérieur de laquelle on diffusera ultérieurement, pour chaque transistor, une seule région N+ fortement dopée et moins profonde que la région 22, pour constituer la source du transistor, le canal étant constitué par une portion de cette région 22 (d'où la même tension de seuil pour le NMOS HT et le NMOS BT).

3) Là où on désire réaliser des transistors MOS haute tension à canal P, on forme une région P− 24 à l'intérieur de laquelle on diffusera ultérieurement, pour chaque transistor, une seule région de type P+ fortement dopée et moins profonde que la région 24, pour constituer le drain du transistor, le canal étant constitué par une portion de la couche épitaxiale 16 de type N.

4) Si l'isolement entre zones actives se fait par jonction (murs d'isolement de type P comme c'est le cas dans l'exemple décrit), on formera une région P− 26 à l'endroit de ces murs d'isolement, c'est-à-dire à l'aplomb de chacune des régions diffusées 14, de telle manière que chaque région 14 rejoigne une région 26 correspondante pour compléter le mur d'isolement qui traverse alors la totalité de l'épaisseur de la couche épitaxiale 16.

Ces différentes régions de type P− sont formées simultanément par implantation ionique localisée (avec une résine de masquage appropriée déposée et gravée selon un motif correspondant aux régions à former). L'impureté implantée est de préférence du bore avec une dose qui peut être de l'ordre de $1,5 \times 10^{13}$ atomes/cm². Cette implantation est suivie d'un traitement thermique de diffusion pour que les régions P− atteignent une profondeur suffisante (dictée essentiellement par la hauteur désirée pour les caissons contenant les transistors MOS à canal N). A titre d'exemple, la concentration superficielle en impuretés de type P dans les régions P− devient de l'ordre de $10^{16}$ atomes/cm³ en fin de diffusion.

L'étape suivante consiste à former, par un procédé d'oxydation localisée classique, des régions d'oxyde de silicium épais entourant les zones actives, par exemple entourant chaque transistor MOS.

Ces régions d'oxyde épais serviront notamment de support aux interconnexions métalliques du circuit.

Pour cela, on dépose une couche de nitrure de silicium 28 que l'on grave pour éliminer là où on veut faire croître l'oxyde épais ; on effectue une implantation d'impuretés de type N (arsenic) à certains endroits délimités par un masque de résine, puis une implantation de type P (bore) à d'autres endroits délimités par un autre masque de résine. Ces implantations dites « de champ », situées ultérieurement sous l'oxyde épais, sont destinées à éviter la mise en conduction des transistors MOS parasites formés sous l'oxyde épais ; ces implantations sont classiques et n'ont pas été représentées pour ne pas surcharger les figures. La figure 4 montre la structure intégrée à ce stade de la fabrication.

On effectue alors un traitement thermique oxydant qui produit la croissance de l'oxyde épais là où il n'y a pas de nitrure après quoi on retire le nitrure. On peut noter que pendant ce traitement thermique se produit une diffusion des impuretés implantées dans les régions P− (20, 22, 24, 26).

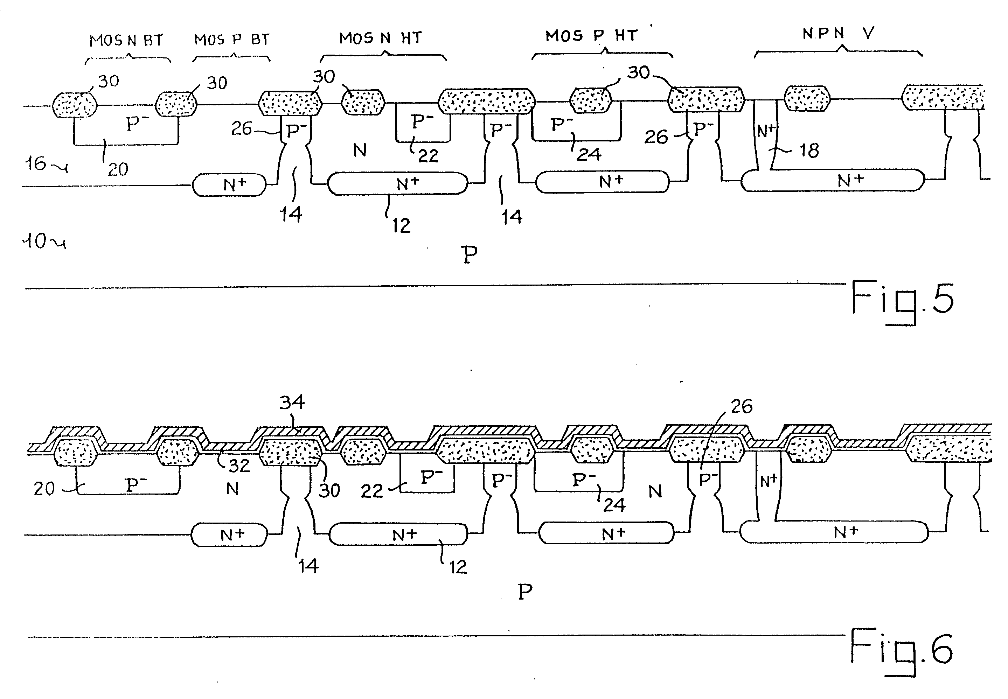

La figure 5 représente l'état de la structure à la fin de cette étape, avec des zones d'oxyde épais 30 à divers endroits, et plus précisément à des endroits où l'on désire éviter qu'une interconnection métallique ou en silicium polycristallin, ne passe à proximité immédiate de la surface semiconductrice et n'induise par effet de champ un canal (ou couche d'inversion) indésirable.

Par exemple, une région d'oxyde épais 30 est particulièrement désirable entre la région de drain et la région de canal des transistors MOS haute tension.

En ce qui concerne les transistors bipolaires éventuellement présents, on peut prévoir une région d'oxyde épais 30 entourant le puits d'accès 18 et la région de base de ces transistors.

L'étape suivante consiste à former uniformément sur toutes les surfaces dénudées de silicium monocristallin, entre les régions d'oxyde épais 30, une couche mince d'oxyde de silicium destinée à former l'oxyde de grille des transistors MOS. Cette couche, 32, est formée par oxydation thermique de la tranche semiconductrice.

Après cela, on dépose uniformément, par décomposition chimique en phase gazeuse et à basse pression (à partir de silane), une couche uniforme 34 de silicium polycristallin, de quelques centaines de nanomètres (figure 6).

Cette couche est dopée soit « in situ », c'est-à-dire pendant son dépôt, soit après le dépôt, par diffusion de phosphore par exemple (prédépôt de POCl₃), pour obtenir une conductivité suffisante du silicium polycristallin.

On procède alors à la gravure du silicium polycristallin et de l'oxyde mince, à l'aide d'un plasma de CF₄ par exemple et d'un masque de résine, pour définir d'une part les grilles des différents transistors MOS basse et haute tension, et d'autre part éventuellement un certain nombre d'interconnexions en silicium polycristallin.

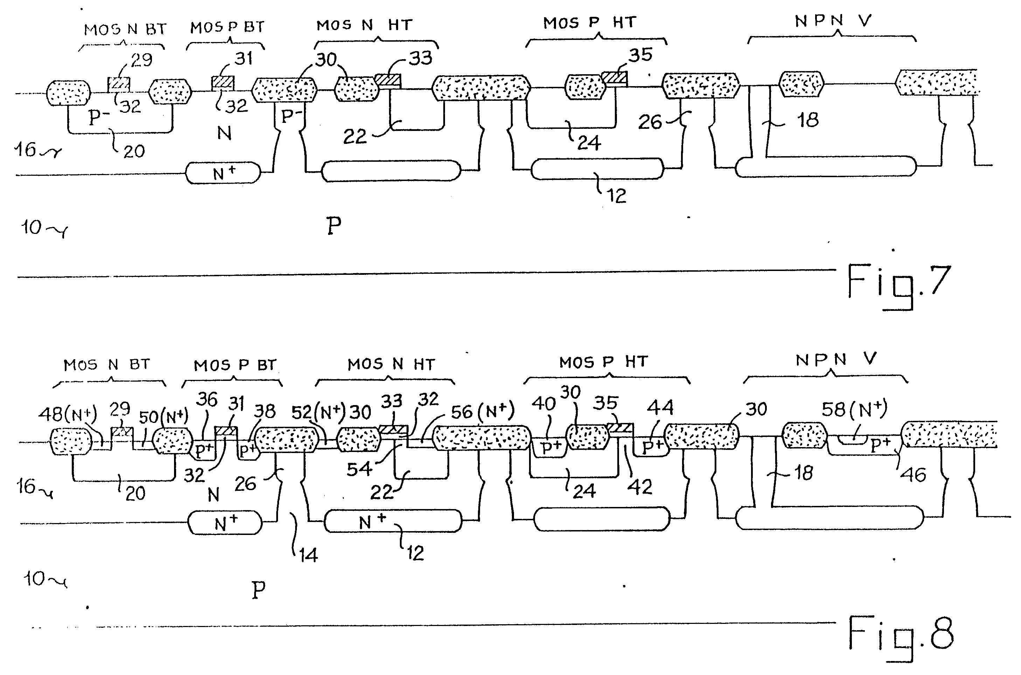

La figure 7 représente la structure intégrée à ce stade de fabrication, après enlèvement du masque de résine.

Pour les transistors MOS basse tension à canal N, la grille, 29, reposant sur de l'oxyde mince, passe à l'intérieur de la surface d'un caisson 20 de type P⁻ et permet la formation d'une zone de source et d'une zone de drain dans ce caisson de part et d'autre de la grille ; pour les transistors MOS basse tention à canal P, la grille 31 passe en dehors d'une région de type P⁻ et permet la formation d'une zone de source et d'une zone de drain de part et d'autre de la grille en dehors d'une région de type P⁻ ; pour les transistors MOS haute tension à canal N, la grille 33 passe à cheval sur la frontière entre une région 22 de type P⁻ et la couche épitaxiale, et elle permet la formation d'une zone de source dans cette région 22 d'un côté de la grille, d'une zone de drain en dehors de cette région 22 de l'autre côté de la grille, et d'une zone de canal dans la région 22 sous la grille ; enfin, pour les transistors MOS haute tension à canal P, la grille 35 passe à cheval sur la frontière entre la couche épitaxiale et une région 24 de type P⁻, et elle permet la formation d'une zone de source dans la couche épitaxiale en dehors de cette région 24 d'un côté de la grille, d'une zone de drain dans la région 24 de l'autre côté de la grille et d'une zone de canal dans la couche épitaxiale en dehors de la région 24, sous la grille.

Le silicium polycristallin qui subsiste sert alors de masque d'autoalignement pour les étapes d'implantation ionique qui suivent.

La première implantation est une implantation d'impuretés de type P à concentration élevée, destinée à former des régions de source et de drain de type P⁺ des transistors MOS à canal P ainsi que les régions de base des transistors bipolaires NPN s'il y a lieu. Pour cela, on dépose et on grave une couche de résine qui masque les zones qui ne doivent pas subir d'implantation de type P⁺, à savoir l'ensemble des transistors MOS à canal N, haute ou basse tension, et le puits d'accès 18 du collecteur des transistors NPN. Pour les transistors MOS à canal P non masqués par la résine, ce sont les régions d'oxyde épais et les grilles de silicium polycristallin qui servent de masque délimitant précisément les régions implantées de type P⁺. L'implantation est effectuée par exemple avec du bore.

Ces régions de type P⁺ sont respectivement (figure 8) :
— des régions 36, constituant le drain de transistors MOS basse tension à canal P, implantées directement dans la couche épitaxiale 16 de type N entre une grille 31 et une région d'oxyde épais 30.
— des régions 38 constituant la source de ces mêmes transistors, également implantées dans la couche épitaxiale de type N entre une grille 31 et de l'oxyde épais 30 ;
— des régions 40 constituant le drain de transistors MOS haute tension à canal P ; ces régions 40 sont implantées à l'intérieur des régions 24 de type P⁻, et sont moins profondes qu'elles ; on notera d'autre part qu'une distance relativement importante, mais quand même inférieure à la profondeur de la région 24, sépare le bord de la région 40 (du côté du canal) de la région de canal 42 proprement dite ; ce qu'on appelle ici région de canal 42 est la région de type N qui est recouverte par la grille de transistor ou plus précisément par la portion de grille qui n'est séparée de la surface semiconductrice que par une couche d'oxyde mince 32 et qui peut donc contrôler directement la formation d'un canal ;
— des régions 44 constituant la source des transistors MOS haute tension à canal P ; ces régions sont implantées dans la couche épitaxiale entre la grille 35 et une zone d'oxyde épais,
— éventuellement des régions 46 constituant la base des transistors bipolaires NPN.

On élimine alors la résine de masquage utilisée pendant l'implantation de type P⁺ et l'on effectue un recuit. On dépose et on grave une autre couche de résine en vue d'une implantation (ou diffusion) de type N⁺ ; cette couche de résine masque les transistors qui ne doivent pas subir cette implantation, à savoir les transistors MOS à canal P (basse tension ou haute tension) et la région de base des transistors NPN. Pour les transistors non masqués, l'oxyde épais 30 et les régions de silicium polycristallin servent de masque délimitant précisément les régions implantées de type N⁺ ; l'implantation peut être effectuée avec de l'arsenic ; une diffusion d'arsenic en ampoule est aussi possible.

Ces régions de type N⁺ sont moins profondes que les régions de type P⁺ et sont respectivement (figure 8)
— des régions 48 de drain des transistors MOS basse tension à canal N, implantées dans la région 20 de type P⁻ entre une grille 29 et une zone d'oxyde épais ;
— des régions 50 de source de ces transistors, également implantées dans la région 20 entre une grille 29 et une zone d'oxyde épais ;
— des régions 52 de drain des transistors MOS haute tension à canal N, implantées directement dans la couche épitaxiale originelle de type N ; ces régions sont espacées, d'une distance relativement importante mais inférieure à l'épaisseur de la couche épitaxiale, de la région de canal proprement dite 54 de ces transistors, c'est-à-dire de la région de type P⁻ directement recouverte (à travers de l'oxyde mince 32) par une grille de silicium polycristallin 33. Sur cette distance, la couche épitaxiale est surmontée d'une zone d'oxyde épais 30. Dans ces conditions, les régions 52 sont entièrement délimitées par de l'oxyde épais 30 ;
— des régions 56 diffusées dans les régions 22 et constituant les régions de source de transistors MOS haute tension à canal N, l'espace entre le bord d'une région 56 et le bord de la région 22 dans laquelle elle se trouve constituant la région de canal 54 de ces transistors ; les régions 56 sont délimitées par les grilles 33 et des zones d'oxyde épais 30 ;

— éventuellement des régions 58 constituant l'émetteur de transistors bipolaires NPN verticaux, ces régions étant diffusées à l'intérieur des régions de base 46. Le puits d'accès 18 à la couche enterrée peut également subir cette opération d'implantation peu profonde de type N+.

Le procédé de fabrication se termine par des étapes classiques non représentées qui sont : un dépôt en phase gazeuse d'une couche isolante d'oxyde de silicium, un fluage de cette couche, une gravure pour ouvrir des contacts, un dépôt métallique (aluminium), une gravure de l'aluminium pour définir un motif d'interconnexions, un dépôt d'une couche isolante de passivation, une gravure de plots de contact pour la connexion aux broches du boîtier, et une encapsulation.

Dans l'exemple de réalisation qui a été décrit, les caissons 20 de type P— contenant les transistors MOS basse tension à canal N sont séparés du substrat par une épaisseur de couche épitaxiale de type N. Cependant, on pourrait prévoir qu'une zone 14 de type P a été diffusée avant la croissance épitaxiale à l'endroit du caisson, de sorte que cette zone remonte ensuite jusqu'au caisson qui constitue alors à la fois un caisson de MOS N basse tension et un mur d'isolement. En reliant ainsi le caisson au substrat, on évite l'apparition d'un phénomène de « latch up », c'est-à-dire la formation d'un thyristor parasite NPNP.

Le procédé qui a été décrit est parfaitement compatible avec la formation de transistors bipolaires PNP latéraux (émetteur et collecteur formés en même temps que le drain des transistors MOS à canal P, base formée par la couche épitaxiale).

Enfin, on peut envisager de réaliser, si le substrat de départ est de type N+, un élément de puissance qui serait ce qu'on appelle un DMOS vertical, c'est-à-dire un MOS à canal N diffusé dont le drain est constitué par la face arrière N+ du substrat, la source est constituée par des zones N+ comme les sources des transistors MOS basse tension à canal N, et la région de canal est diffusée localement avec la diffusion de caisson de type P— des transistors MOS basse tension à canal N.

## Revendications

1. Structure de circuit intégré incorporant des transistors MOS basse tension à canal N et canal P, et des transistors MOS haute tension à canal N et canal P, comprenant :

— une pastille semi-conductrice constituée d'un substrat (10) recouvert d'une couche épitaxiale (16) peu dopée de type N ;

— des premières régions (20) de type P— peu dopées, s'étendant à partir de la surface de la pastille semi-conductrice sur une partie substantielle de la profondeur de la couche épitaxiale (16), ces premières régions (20) constituant des caissons dans lesquels sont formés la source, le drain et le canal des transistors MOS basse tension à canal N ;

— des régions de type P— fortement dopées (36, 38, 40, 44) moins profondes que les premières régions (20) de type P—, s'étendant à partir de la surface de la pastille semi-conductrice et constituant la source et le drain des transistors à canal P ;

— des régions de type N— fortement dopées (48, 50, 52, 56) moins profondes que les premières régions (20) de type P—, s'étendant à partir de la surface de la pastille semi-conductrice et constituant la source et le drain des transistors à canal N ; caractérisée en ce que cette structure comprend en outre :

— à chaque emplacement de transistor MOS haute tension à canal N, une seconde région (22) de type P—, de mêmes profil de concentration et profondeur que les premières régions (20) et constituant une région de canal (54) de ce transistor MOS haute tension à canal N, une région de source (56) de type N+ implantée dans ladite seconde région (22) de type P—, et une région de drain (52) de type N+, en dehors de la seconde région (22) de type P— et séparée d'elle par une zone substantielle de la couche épitaxiale (16) de type N peu dopée, zone non directement contrôlée par la grille (33) du transistor et située entre ladite région de drain (52) et la seconde région (22) de type P— ;

— à chaque emplacement de transistor MOS haute tension à canal P, une troisième région (24) de type P—, de mêmes profil de concentration et profondeur que lesdites premières (20) et secondes (22) régions de type P—, où est implantée une région de drain (40) de type P+, une région de canal (42) du transistor étant constituée par une portion de la couche épitaxiale (16) de type N peu dopée, adjacente à ladite troisième région (24) de type P—, la région de drain (40), implantée dans la troisième région (24), étant écartée de la région de canal (42) par une zone substantielle de la troisième région (24) de type P— non directement contrôlée par la grille (35) du transistor MOS haute tension à canal P, tandis que ce transistor présente une région de source (44) de type P+ en dehors de ladite troisième région (24) de type P—.

2. Structure selon la revendication 1, qui comporte des murs d'isolement séparant au moins certains transistors, et traversant la couche épitaxiale (16), ces murs présentant une partie inférieure (14) de type P partant du substrat, et une partie supérieure (26) de type P— partant de la surface de la pastille semi-conductrice pour rejoindre la partie inférieure (14), caractérisée en ce que ladite partie supérieure (26) présente sensiblement les mêmes profil de concentration et profondeur que lesdites premières (20), secondes (22) et troisièmes (24) régions de type P—.

3. Structure selon la revendication 1 ou la revendication 2, caractérisée en ce que lesdites régions de type P+ (36, 38, 40, 44) sont substantiellement plus profondes que lesdites régions de type N+ (48, 50, 52, 56).

4. Structure selon la revendication 3, comportant des couches enterrées (12) de type N+ à la frontière entre le substrat (10) et la couche épitaxiale (16), caractérisée en ce qu'elle comprend au moins un transistor bipolaire NPN ayant pour base une région (46) de type P+, de mêmes profil de dopage et profondeur que lesdites régions de type P+ (36, 38, 40, 44) des transistors MOS à canal P, avec, implantée dans cette région (46) de type P+, une région (58) de type N+ formant émetteur et présentant les mêmes profil de dopage et profondeur que lesdites régions de type N+ (48, 50, 52, 56) des transistors MOS à canal N, tandis qu'un collecteur est connecté par une couche enterrée (12) de type N+ sous-jacente, reliée à la surface de la pastille semiconductrice à l'écart de la région de base (46) par un puits (16) de type N+ traversant la couche épitaxiale (16).

5. Procédé de fabrication de circuits intégrés incorporant des transistors MOS à canal N et à canal P dont certains ont une tenue en tension améliorée, caractérisé en ce que

a) on effectue une implantation ionique localisée d'impuretés de type P à faible concentration dans une couche épitaxiale peu dopée de type N, simultanément dans des régions qui sont

— des premières régions (20) constituant des caissons destinés à enfermer source (50), drain (48) et canal de certains transistors MOS à canal N dits transistors MOS N basse tension ;

— des secondes régions (22) destinées à enfermer uniquement la source (56) et le canal (54) de transistors MOS à canal N dits transistors MOS N haute tension ;

— des troisièmes régions (24) destinées à enfermer uniquement le drain (40) de transistors MOS à canal P dits transistors MOS P haute tension ;

b) on forme et on grave une couche d'oxyde mince (32) surmontée d'une couche de silicium polycristallin (34) pour former :

— des grilles passant à l'intérieur des premières régions en permettant la formation dans ces régions d'une zone de source (50) et d'une zone de drain (48) de part et d'autre de la grille ;

— des grilles venant à cheval sur la frontière entre une deuxième région (22) de type P— et la couche épitaxiale (16) de type N, en permettant la formation d'une zone de source (56) dans la deuxième région d'un côté de la grille, d'une zone de drain (52) dans la couche épitaxiale de l'autre côté de la grille, et d'une zone de canal (54) sous la grille dans la deuxième région ;

— des grilles venant à cheval sur la frontière entre une troisième région (24) de type P— et la couche épitaxiale (16) de type N, en permettant la formation d'une zone de source (44) dans la couche épitaxiale d'un côté de la grille, d'une zone de drain (40) dans la troisième région de l'autre côté de la grille, et d'une zone de canal (42) dans la couche épitaxiale sous la grille ;

c) on implante localement d'une part une impureté de type P et d'autre part une impureté de type N pour former des régions (36, 38, 40, 44) de type P— constituant la source et le drain des transistors à canal P et des régions (48, 50, 52, 56) de type N+ constituant la source et le drain des transistors à canal N, les régions de drain des transistors MOS haute tension étant écartées latéralement des régions contrôlées par la grille de ces transistors.

6. Procédé suivant la revendication 5, pour obtenir un circuit intégré pourvu de murs d'isolement au moins entre certains transistors, caractérisé en ce que, ayant formé un dessin de ces murs par implantation ionique d'impuretés de type P à la surface d'un substrat (10) avant la croissance de la couche épitaxiale (16), puis formé une partie inférieure (14) des murs par diffusion desdites impuretés de type P implantées dans la couche épitaxiale (16) vers la surface de cette couche jusqu'à une profondeur correspondant à la profondeur d'implantation de l'opération (a) ultérieure, on effectue, lors de cette opération (a), une implantation ionique d'impuretés de type P à faible concentration à l'aplomb desdites parties inférieures (14) de murs, en sorte de constituer des parties supérieures (26) de murs d'isolement qui s'étendent de la surface de la couche épitaxiale (16) jusqu'au contact desdites portions inférieures (14).

**Claims**

1. An integrated circuit structure incorporating N channel and P channel MOS low voltage transistors and N channel and P channel MOS high voltage transistors comprising :

— a semiconductor chip consisting of a substrate (10) covered by a lightly doped N type epitaxial layer (16) ;

— first lightly doped P— type regions (20) extending from the surface of the semiconductor chip through a substantial part of the depth of the epitaxial layer (16), these first regions (20) constituting wells in which the source, drain and channel of N channel MOS low voltage transistors are formed ;

— highly doped P+ type regions (36, 38, 40, 44), which are not as deep as the first P— type regions (20), extending from the surface of the semiconductor chip and constituting the source and the drain of P channel transistors ;

— highly doped N+ type regions (48, 50, 52, 56), which are not as deep as the first P— type regions (20), extending from the surface of the semiconductor chip and constituting the source and the drain of N channel transistors ;

characterized in that this structure also comprises :

— at each N channel MOS high voltage transistor location, a second P— type region (22) with the same profile of concentration and depth as the first regions (20) and constituting a channel region (54) of this N channel MOS high voltage transistor, an N+ type source region (56) implanted in the said second P— type region (22) and an N+ type drain region (52) which is outside the second P— type region (22) and is separated from the latter by a substantial zone of the lightly doped N type epitaxial layer (16), which zone is not directly controlled by the gate (33) of the transistor and is situated between the said drain region (52) and the second P— type region (22) ;

— at each P channel MOS high voltage transistor location, a third P— type region (24), with the same profile of concentration and depth as the first (20) and the second (22) P— type regions, in which is implanted a P+ type drain region (40), a channel region (42) of the transistor being constituted by a part of the lightly doped N type epitaxial layer (16) which is adjacent to the said third P— type region (24), the drain region (40) which is implanted in the third region (24) being separated from the channel region (42) by a substantial zone of the third P— type region (24) which is not directly controlled by the gate (35) of the P channel MOS high voltage transistor, and this transistor comprises a P+ type source region (44) outside the said third P— type region (24).

2. A structure according to Claim 1 which comprises insulating walls which separate at least some transistors and pass through the epitaxial layer (16), these walls comprising a P type lower part (14), starting from the substrate, and a P— type upper part (26), starting from the surface of the semiconductor chip and joining the lower part (14), characterized in that the said upper part (26) has substantially the same profile of concentration and depth as the said first (20), second (22) and third (24) P— type regions.

3. A structure according to Claim 1 or Claim 2, characterized in that the said P+ type regions (36, 38, 40, 44) are substantially deeper than the said N+ type regions (48, 50, 52, 56).

4. A structure according to Claim 3 comprising N— type buried layers (12) at the boundary between the substrate (10) and the epitaxial layer (16), characterized in that it comprises at least one bipolar NPN transistor having as its base a P+ type region (46) with the same profile of doping and depth as the said P+ type regions (36, 38, 40, 44) of the P channel MOS transistors, and having, implanted in this P+ type region (46), an N+ type region (58) which forms an emitter and has the same profile of doping and depth as the said N+ type regions (48, 50, 52, 56) of the N channel MOS transistors, whilst a collector is connected by a sub-jacent N+ type buried layer (12) which is connected to the surface of the semiconductor chip at a distance from the base region (46) by an N+ type well (16) stretching across the epitaxial layer (16).

5. A process for manufacturing integrated circuits incorporating N channel and P channel MOS transistors some of which have improved voltage ratings, characterized in that

a) localized ionic implantation of a low concentration of P type impurities in a lightly doped N type epitaxial layer is performed simultaneously in regions which are

— first regions (20) constituting wells which are intended to enclose the source (50), drain (48) and channel of certain N channel MOS transistors called low voltage MOS N transistors ;

— second regions (22) intended to enclose only the source (56) and the channel (54) of N channel MOS transistors called high voltage MOS N transistors ;

— third regions (24) intended to enclose only the drain (40) of P channel MOS transistors called high voltage MOS P transistors ;

b) a thin layer of oxide (32) covered by a layer of polycrystalline silicon (34) is formed and etched to form :

— gates which extend into the interior of the first regions and permit the formation in these regions of a source zone (50) and a drain zone (48) on either side of the gate ;

— gates which straddle the boundary between a second P— type region (22) and the N type epitaxial layer (16) and permit the formation of a source zone (56) in the second region on one side of the gate, a drain zone (52) in the epitaxial layer on the other side of the gate, and a channel zone (54) beneath the gate in the second region ;

— gates which straddle the boundary between a third P— type region (24) and the N type epitaxial layer (16) and permit the formation of a source zone (44) in the epitaxial layer on one side of the gate, a drain zone (40) in the third region on the other side of the gate, and a channel zone (42) in the epitaxial layer beneath the gate ;

c) local implantation is performed of, on the one hand, a P type impurity and, on the other hand, an N type impurity to form P+ type regions (36, 38, 40, 44) constituting the source and the drain of P channel transistors and N+ type regions (48, 50, 52, 56) constituting the source and the drain of N channel transistors, the drain regions of the high voltage MOS transistors being separated laterally from the regions controlled by the gate of these transistors.

6. A process according to Claim 5 to obtain an integrated circuit provided with insulating walls at least between some transistors, characterized in that, a pattern for these walls having been formed by ionic implantation of P type impurities in the surface of a substrate (10) before the growth of the epitaxial layer (16), and a lower part (14) of these walls having then been formed by diffusion of the said P type impurities implanted in the epitaxial layer (16) towards the surface of this layer to a depth corresponding to the depth of implantation in the subsequent operation (a), a low concentration of P type ionic impurities is implanted directly during this operation (a) in line with the said lower parts (14) of the walls so as to constitute the upper parts (26) of the insulating walls which extend from the surface of the epitaxial layer (16) until they contact the said lower parts (14).

**Patentansprüche**

1. Integrierte Schaltungsstruktur mit N-Kanal- und P-Kanal-MOS-Niederspannungstransistoren sowie mit N-Kanal- und P-Kanal-MOS-Hochspannungstransistoren mit

— einem aus einem Substrat (10) bestehenden Halbleiterplättchen, welches Substrat mit einer gering dotierten epitaxialen N-Typ-Schicht (16) bedeckt ist;

— gering dotierten ersten P⁻-Typ-Zonen (20), die sich ausgehend von der Oberfläche des Halbleiterplättchens über einen wesentlichen Teil der Tiefe der epitaxialen Schicht (16) erstrecken, welche ersten Zonen (20) Kasten bilden, in denen die Source, der Drain und der Kanal des N-Kanal-MOS-Niederspannungstransistors gebildet sind,

— stark dotierte P⁺-Zonen (36, 38, 40, 44), die weniger tief sind als die ersten P⁻-Zonen (20), und die sich von der Oberfläche des Halbleiterplättchens ausgehend erstrecken und die Source und den Drain des P-Kanal-Transistors bilden;

— stark dotierte N⁺-Zonen (48, 50, 52, 56), die weniger tief sind als die ersten P⁻-Zonen (20), und die sich von der Oberfläche des Halbleiterplättchens ausgehend erstrecken und die Source und den Drain des N-Kanal-Transistors bilden;

dadurch gekennzeichnet, daß diese Struktur außerdem enthält:

— an jeder Stelle des N-Kanal-MOS-Hochspannungstransistors eine eine Kanalzone (54) dieses N-Kanal-MOS-Hochspannungstransistors darstellende zweite P⁻-Typ-Zone (22) mit gleichen Konzentrations- und Tiefenprofilen wie die ersten Zonen (20), eine in die zweite P⁻-Typ-Zone (22) implantierte N⁺-Typ-Sourcezone (56), und außerhalb der zweiten P⁻-Typ-Zone (22) eine N⁺-Typ-Drainzone (52), die von der genannten zweiten Zone durch eine wesentliche Zone der gering dotierten epitaxialen N-Typ-Schicht (16) getrennt ist, welch letztere Zone vom Transistorgitter (33) nicht direkt kontrolliert wird und zwischen der Drainzone (52) und der zweiten P⁻-Typ-Zone (22) liegt;

— an jedem Platz des P-Kanal-MOS-Hochspannungstransistors eine dritte P⁻-Typ-Zone (24) mit gleichen Konzentrations- und Tiefenprofilen wie die ersten (20) und zweiten (22) P⁻-Typ-Zonen, in welche dritte Zone eine P⁺-Typ-Drainzone (40) implantiert ist, wobei eine Kanalzone (42) des Transistors von einem an die dritte P⁻-Typ Zone (24) angrenzenden Abschnitt der gering dotierten epitaxialen N-Typ-Schicht (16) gebildet wird, wobei die in die dritte Zone (24) implantierte Drainzone (40) von der Kanalzone (42) durch einen wesentlichen Bereich der dritten P⁻-Typ-Zone (24) entfernt ist, der nicht direkt vom Gitter (35) des P-Kanal-MOS-Hochspannungstransistors kontrolliert wird, während der Transistor eine P⁻-Typ-Sourcezone (44) außerhalb der dritten P⁻-Typ-Zone (24) aufweist.

2. Struktur nach Anspruch 1 mit Isolierungswänden, die mindestens einige Transistoren separieren und die epitaxiale Schicht (16) durchqueren, welche Wände einen vom Substrat ausgehenden unteren P-Typ-Teil (14) und einen, um den unteren Teil (14) zu treffen, von der Oberfläche des Halbleiterplättchens ausgehenden oberen P⁻-Typ-Teil (26) aufweisen, dadurch gekennzeichnet, daß der obere Teil (26) im wesentlichen die gleichen Konzentrations- und Tiefenprofile aufweist wie die ersten (20), zweiten (22) und dritten (24) P⁻-Typ-Zonen.

3. Struktur nach Anspruch 1 oder 2, dadurch gekennzeichnet, daß die P⁻-Typ-Zonen (36, 38, 40, 44) wesentlich tiefer sind als die N⁺-Typ-Zonen (48, 50, 52, 56).

4. Struktur nach Anspruch 3 mit an der Grenze zwischen dem Substrat (10) und der epitaxialen Schicht (16) vergrabenen N⁺-Typ-Schichten (12) dadurch gekennzeichnet, daß sie mindestens einen bipolaren NPN-Transistor aufweist, dessen Basis eine P⁺-Typ-Zone (46) mit gleichen Dotierungs- und Tiefenprofilen wie die P⁺-Typ-Zonen (36, 38, 40, 44) der P-Kanal-MOS-Transistoren ist, welche Zone eine in die P⁺-Typ-Zone (46) implantierte N⁺-Typ-Zone (58) aufweist, die den Emitter bildet und die gleichen Dotierungs- und Tiefenprofile aufweist wie die N⁺-Typ-Zonen (48, 50, 52, 56) der N-Kanal-MOS-Transistoren, während ein Kollektor durch eine darunter liegende vergrabene N⁺-Typ-Schicht (12) angeschlossen ist, die mit der Oberfläche des Halbleiterplättchens im Abstand von der Basiszone (46) durch einen die epitaxiale Schicht (16) durchquerenden N⁺-Typ-Graben (18) vom Typ N⁺ verbunden ist.

5. Verfahren zur Herstellung von integrierten Schaltungen mit N-Kanal- und mit P-Kanal-MOS-Transistoren, von denen einige ein verbessertes Spannungsverhalten haben, dadurch gekennzeichnet, daß

a) eine örtlich begrenzte Ionenimplantation von P-Typ-Verunreinigungen schwacher Konzentration in einer gering dotierten epitaxialen N-Typ-Schicht gleichzeitig in Zonen durchgeführt wird, die

— erste Zonen (20) sind, die als Kasten zur Aufnahme von Source (50), Drain (48) und Kanal einiger N-Kanal-MOS-Transistoren, genannt MOS N-Niederspannungstransistoren, dienen sollen;

— zweite Zonen (22) sind, die nur die Source (56) und den Kanal (54) von N-Kanal-MOS-Transistoren, genannt MOS N-Hochspannungstransistoren, aufnehmen sollen;

— dritte Zonen (24) sind, die nur den Drain (40) von P-Kanal-MOS-Transistoren, genannt MOS P-Hochspannungstransistoren, aufnehmen sollen;

b) eine dünne Oxydschicht (32) geformt und geätzt wird, die von einer polykristallinen Siliziumschicht (34) überlagert ist, um

— in das Innere der ersten Zonen führende Gitter zu formen, wobei die Bildung einer Sourcezone (50) und einer Drainzone (48) in diesen Zonen zu beiden Seiten des Gitters zugelassen wird;

auf der Grenze zwischen einer zweiten P⁻-Typ-Zone (22) und der epitaxialen N-Typ-Schicht (16) aufsitzende Gitter zu formen, wobei die Bildung einer Sourcezone (56) in der zweiten Zone auf der einen Seite des Gitters, einer Drainzone (52) in der epitaxialen Schicht auf der anderen Seite des Gitters, und einer Kanalzone (54) unter dem Gitter der zweiten Zone zugelassen wird;

auf der Grenze zwischen einer dritten P⁻-Zone (24) und der epitaxialen N-Typ-Schicht (16) aufsitzende Gitter zu formen, wobei die Bildung einer Sourcezone (44) in der epitaxialen Schicht auf der einen Seite des Gitters, einer Drainzone (40) in der dritten Zone auf der anderen Seite des Gitters, und einer Kanalzone (42) in der epitaxialen Schicht unter dem Gitter zugelassen wird ;

c) örtlich einerseits eine P-Typ-Verunreinigung und anderseits eine N-Typ-Verunreinigung implantiert wird, um $P^-$-Typ-Zonen (36, 38, 40, 44) zu bilden, die die Source und den Drain der P-Kanal-Transistoren darstellen, und $N^+$-Typ-Zonen (48, 50, 52, 56), die die Source und den Drain der N-Kanal-Transistoren bilden, wobei die Drainzonen der MOS-Hochspannungstransistoren seitlich von den vom Gitter dieser Transistoren kontrollierten Zonen entfernt sind.

6. Verfahren nach Anspruch 5 zur Herstellung einer mit Isolierwänden zumindest zwischen einigen Transistoren versehenen integrierten Schaltung, dadurch gekennzeichnet, daß, nachdem ein Muster dieser Wände durch Ionenimplantation von P-Typ-Verunreinigungen auf der Oberfläche eines Substrats (10) vor dem Wachsen der epitaxialen Schicht (16), und dann ein unterer Teil (14) der Wände durch Diffundieren der in die epitaxiale Schicht (16) implantierten P-Typ-Verunreinigungen gegen die Oberfläche dieser Schicht bis zu einer der Tiefe der Implantation nach dem nachfolgenden Vorgang (a) entsprechenden Tiefe gebildet wurde, bei diesem Vorgang (a) eine Ionenimplantation von P-Typ-Verunreinigungen schwacher Konzentration lotrecht auf die unteren Teile (14) der Wände durchgeführt wird, um obere Teile (26) der Isolierwände zu bilden, die sich von der Oberfläche der epitaxialen Schicht (16) bis zur Berührung der unteren Abschnitte (14) erstrecken.

Sb    B    Sb    B    Sb    B    Sb    B

12 (N⁺)   14(P⁺)   12   14   12 (N⁺)   14(P⁺)   12   14

10

P

Fig.1

N

16

N⁺   P⁺   N⁺   P⁺   N⁺   P⁺   N⁺   P⁺

12   14   12   14   12

10

P

Fig.2

EP 0 179 693 B1

NPN V

16

18

N⁺

N

14    P    14    P    14    P    14    P

N⁺    P    N⁺    P    N⁺    P    N⁺

12    12    12    12

P

10

**Fig.3**

EP 0 179 693 B1

MOS N BT          MOS N HT          MOS P HT          NPN V

28    28    28    26    28    26    24    26    28    26

P⁻                P⁻    P⁻    P⁻    P⁻    P⁻    P⁻

20    N    14    22    14    P    14    N⁺    18    P    14

16

N⁺    P    N⁺    P    N⁺    P    N⁺    P

12    12    12    12

10

P

**Fig.4**

EP 0 179 693 B1

MOS N BT    MOS P BT      MOS N HT         MOS P HT          N.P.N  V

Fig.5

Fig.6

EP 0 179 693 B1

MOS N BT   MOS P BT   MOS N HT   MOS P HT   NPN V

29   31   30   33   35

32   32   P⁻   22   24   26   18

16   20   N   12

10   P

Fig.7

MOS N BT   MOS P BT   MOS N HT   MOS P HT   NPN V

48(N⁺)  29  50(N⁺)  36  31  38  52(N⁺)  30  33  32  56(N⁺)  40  30  35  44  30  58(N⁺)

32  P⁺  P⁺  54  P⁺  42  P⁺  P⁺

16  20  32  26  22  24  42  18  46

N  54  14  12

10  P

Fig.8